# NEW EUROPEAN PATENT SPECIFICATION

(11) **EP 3 133 650 B2**
(45) Date of publication and mention of the opposition decision: **18.03.2026**
(45) Mention of the grant of the patent: 23.09.2020
(21) Application number: 16182474.3
(22) Date of filing: 02.08.2016
(51) Int. Cl.: H01L 31/078, H01L 31/18

(54) **FOUR JUNCTION SOLAR CELL FOR SPACE APPLICATIONS**
SOLARZELLE MIT VIERFACHABZWEIGUNG FÜR RAUMFAHRTANWENDUNGEN
CELLULE SOLAIRE À QUATRE JONCTIONS POUR APPLICATIONS SPATIALES

(30) Priority: 17.08.2015 US 201514828206
(43) Date of publication of application: 22.02.2017
(73) Proprietor: SolAero Technologies Corp., Albuquerque, NM 87123 (US)
(72) Inventor: DERKACS, Daniel, Albuquerque, NM 87111 (US)
(74) Representative: Rummler, Felix

(56) References cited:
- EP-A2- 2 264 788
- US-A1- 2012 211 068
- US-A1- 2014 076 401
- US-A1- 2014 182 667
- US-B1- 6 660 928
- CAMPESATO R., GORI G., CASALE M., GABETTA G.: "High Efficiency Four Junction Lattice Matched Solar Cells for Space Applications: Analysis of Radiation Hardness against 1 MeV Electrons", PROCEEDINGS OF THE 29TH EUROPEAN PHOTOVOLTAIC SOLAR ENERGY CONFERENCE AND EXHIBITION, 3 November 2014 (2014-11-03), XP040677850, ISBN: 978-3-936338-34-8
- KING R., BHUSARI D., BOCA A., LARRABEE D., LIU X.-Q: "Band gap-voltage offset and energy production in next-generation multijunction solar cells", EU PVSEC PROCEEDINGS : 25TH EUROPEAN PHOTOVOLTAIC SOLAR ENERGY CONFERENCE AND EXHIBITION / 5TH WORLD CONFERENCE ON PHOTOVOLTAIC ENERGY CONVERSION, 6 September 2010 (2010-09-06), XP040530705, ISBN: 978-3-936338-26-3
- CAMPESATO R., GORI G., GRECO E., SCACCABAROZZI A., BINETTI S., LE DONNE A.: "High efficiency AlInGaP and AlInGaAs solar cells for 32% fours junction devices", PROCEEDINGS / EU PVSEC 2013, 28TH EUROPEAN PHOTOVOLTAIC SOLAR ENERGY CONFERENCE AND EXHIBITION, PARC DES EXPOSITIONS PARIS NORD VILLEPINTE, PARIS, FRANCE, CONFERENCE 30 SEPTEMBER - 04 OCTOBER 2013, 1 October 2013 (2013-10-01), XP040634861, ISBN: 978-3-936338-33-1
- LE DONNE A ET AL: "Optical and electrical characterization of AlGaInP solar cells", SOLAR ENERGY MATERIALS AND SOLAR CELLS, ELSEVIER SCIENCE PUBLISHERS, AMSTERDAM, NL, vol. 94, no. 12, 1 December 2010 (2010-12-01), pages 2002 - 2006, XP027383816, ISSN: 0927-0248, [retrieved on 20100701]
- RICHARD R KING: "Raising the Efficiency Ceiling in Multijunction Solar Cells", 16 February 2011 (2011-02-16), XP055482255, Retrieved from the Internet <URL:https://iee.ucsb.edu/sites/iee.ucsb.edu/files/docs/king_richard_2011.pdf> [retrieved on 20180607]
- DIMROTH ET AL.: "NEXT GENERATION GalnP/GalnAs/Ge MULTI-JUNCTION SPACE SOLAR CELLS", 17TH. E.C. PHOTOVOLTAIC SOLAR ENERGY CONFERENCE. MUNICH, GERMANY, OCT. 22 - 26, 2001; [PROCEEDINGS OF THE INTERNATIONAL PHOTOVOLTAIC SOLAR ENERGY CONFERENCE], 22 October 2001 (2001-10-22), pages 2150 - 2154, XP001139903
- HECKELMANN ET AL.: "Investigations on AIGaAs Solar Cells Grown by MOVPE", IEEE JOURNAL OF PHOTOVOLTAICS, vol. 5, no. 1, January 2015 (2015-01-01), XP011568526, DOI: 10.1109/JPHOTOV.2014.2367869
- A.S. GUDOVSKIKH ET AL.: "Anisotype GaAs Based Heterojunctions for III-V Multijunction Solar Cells", 25TH EUROPEAN PHOTOVOLTAIC SOLAR ENERGY CONFERENCE AND EXHIBITION / 5TH WORLD CONFERENCE ON PHOTOVOLTAIC ENERGY CONVERSION, 6 September 2010 (2010-09-06), Valencia, Spain, XP055827483

## Description

### BACKGROUND OF THE INVENTION

### Field of the Invention

The present disclosure relates to solar cells, and more particularly the design and specification of the band gaps in a four junction solar cell based on III-V semiconductor compounds.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to manufacture. Typical commercial III-V compound semiconductor multijunction solar cells have energy efficiencies that exceed 27% under one sun, air mass 0 (AM0), illumination, whereas even the most efficient silicon technologies generally reach only about 18% efficiency under comparable conditions. Under high solar concentration (e.g., 500X), commercially available III-V compound semiconductor multijunction solar cells in terrestrial applications (at AM1.5D) have energy efficiencies that exceed 37%. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

Typical III-V compound semiconductor solar cells are fabricated on a semiconductor wafer in vertical, multijunction structures or stacked sequence of solar subcells, each subcell formed with appropriate semiconductor layers and including a p-n photoactive junction. Each subcell is designed to convert photons over different spectral or wavelength bands to electrical current. After the sunlight impinges on the front of the solar cell, and photons pass through the subcells, the photons in a wavelength band that are not absorbed and converted to electrical energy in the region of one subcell propagate to the next subcell, where such photons are intended to be captured and converted to electrical energy, assuming the downstream subcell is designed for the photon's particular wavelength or energy band.

The energy conversion efficiency of multijunction solar cells is affected by such factors as the number of subcells, the thickness of each subcell, the composition and doping of each active layer in a subcell, and the consequential band structure, electron energy levels, conduction, and absorption of each subcell. Factors such as the short circuit current density (J_{sc}), the open circuit voltage (V_{oc}), and the fill factor are also important. Another parameter of consideration is the difference between the band gap and the open circuit voltage, or (E_{g} -V_{oc}), of a particular active layer.

One of the important mechanical or structural considerations in the choice of semiconductor layers for a solar cell is the desirability of the adjacent layers of semiconductor materials in the solar cell, i.e. each layer of crystalline semiconductor material that is deposited and grown to form a solar subcell, have similar crystal lattice constants or parameters. The present application is directed to solar cells with substantially lattice matched subcells.

CAMPESATO R., GORI G., CASALE M., GABETTA G.: "High Efficiency Four Junction Lattice Matched Solar Cells for Space Applications: Analysis of Radiation Hardness against 1 MeV Electrons" PROCEEDINGS OF THE 29TH EUROPEAN PHOTOVOLTAIC SOLAR ENERGY CONFERENCE AND EXHIBITION, 3 November 2014 (2014-11-03), XP040677850, ISBN 978-3-936338-34-8 discloses a four junction lattice matched solar cell. However, the average band gap value of the four subcells is 1.43 eV.

CAMPESATO R., GORI G., GRECO E., SCACCABAROZZI A., BINETH S., LE DONNE A.: "High efficiency AlInGaP and AlInGaAs solar cells for 32% four junction devices" PROCEEDINGS / EU PVSEC 2013, 28TH EUROPEAN PHOTOVOLTIC SOLAR ENERGY CONFERENCE AND EXHIBITION, PARC DES EXPOSITIONS PARIS NORD VILLPINTE, PARIS, FRANCE, CONFERENCE 30 SEPTEMBER - 04 OCTOBER 2013, 1 October 2013 (2013-10-01), XP040634861, ISBN: 978-3-936338-33-1 discloses a four junction lattice matched solar cell. However, the average band gap value of the four subcells is 1.425 eV.

### SUMMARY OF THE DISCLOSURE

### Objects of the Disclosure

It is an object of the present disclosure to provide increased photoconversion efficiency in a multijunction solar cell for space applications over the operational life of the photovoltaic power system.

It is another object of the present disclosure to provide in a multijunction solar cell in which the selection of the composition of the subcells and their band gaps maximizes the efficiency of the solar cell at a predetermined high temperature (in the range of 50 to 70 degrees Centigrade) in deployment in space at AM0 at a predetermined time after the initial deployment, such time being at least one year.

It is another object of the present invention to provide a lattice matched four junction solar cell in which the current through the bottom subcell is intentionally designed to be substantially greater than current through the top three subcells when measured at the "beginning-of-life" or time of initial deployment.

### Features of the Invention

The present invention relates to a four junction solar cell as defined in claim 1.

Briefly, and in general terms, the present disclosure provides a solar cell comprising an upperfirst solar subcell composed of a semiconductor material having a first band gap; a second solar subcell adjacent to said first solar subcell composed of a semiconductor material having a second band gap smaller than the first band gap and being lattice matched with the upper first solar subcell; a third solar subcell adjacent to said second solar subcell and composed of a semiconductor material having a third band gap smaller than the second band gap and being lattice matched with the second solar subcell; and a fourth solar subcell adjacent to said third solar subcell and composed of a semiconductor material having a fourth band gap smaller than the third band gap; wherein the fourth subcell has a band gap of approximately 0.67 eV, the third subcell has a band gap of approximately 1.41 eV, the second subcell has a band gap in the range of 1.65 to 1.8 eV and the upper first subcell has a band gap in the range of 2.0 to 2.15 eV, wherein the average band gap of all four subcells, namely the sum of the four band gaps of each subcell divided by four is greater than 1.44 eV.

The upper first subcell is composed of indium gallium aluminum phosphide; the second solar subcell includes an emitter layer composed of indium gallium phosphide or aluminum gallium arsenide, and a base layer composed of aluminum gallium arsenide; the third solar subcell is composed of indium gallium arsenide; and the fourth subcell is composed of germanium.

In some embodiments, there further comprises a distributed Bragg reflector (DBR) layer adjacent to and between the third and the fourth solar subcells and arranged so that light can enter and pass through the third solar subcell and at least a portion of which can be reflected back into the third solar subcell by the DBR layer.

### BRIEF DESCRIPTION OF THE DRAWINGS

The invention will be better and more fully appreciated by reference to the following detailed description when considered in conjunction with the accompanying drawings, wherein:

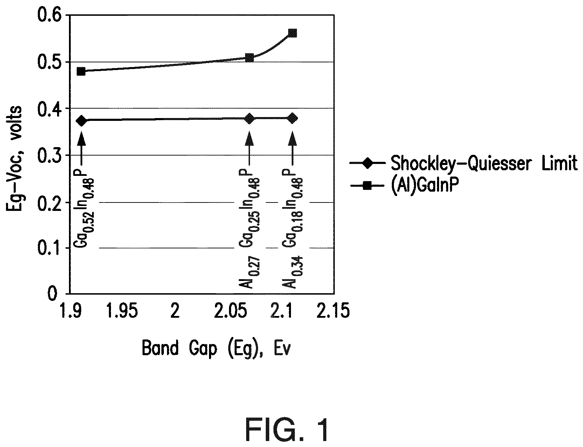

FIG. 1 is a graph representing the BOL value of the parameter E_{g} - V_{oc} at 28° C plotted against the band gap of certain binary materials defined along the x-axis;

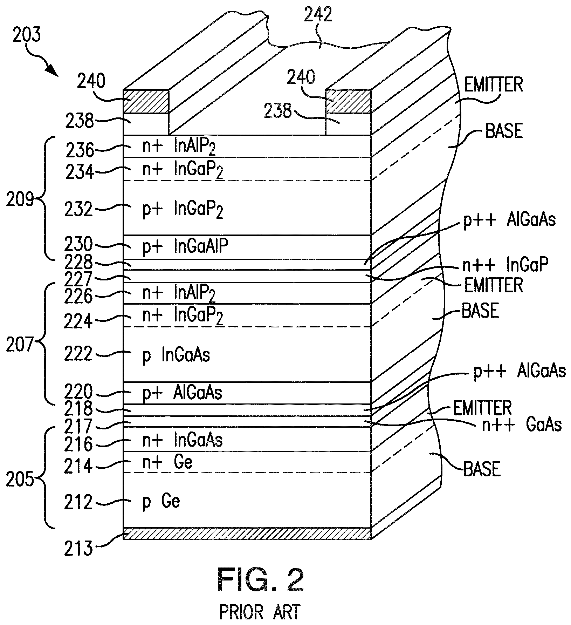

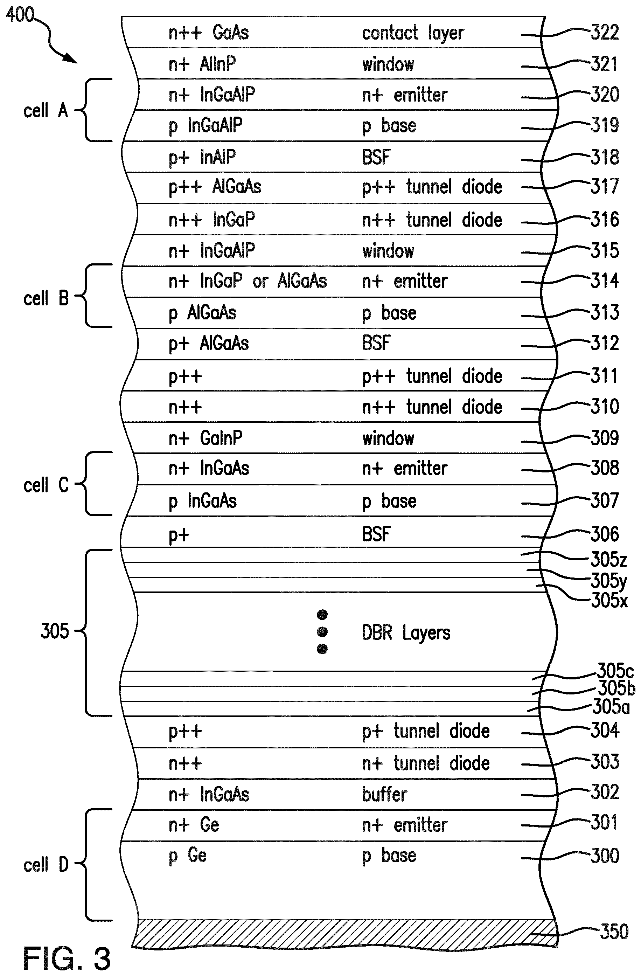

FIG. 2 is a cross-sectional view of the solar cell of a three junction solar cell after several stages of fabrication including the deposition of certain semiconductor layers on the growth substrate up to the grid lines, as known in the prior art; and FIG. 3 is a cross-sectional view of the solar cell of a four junction solar cell after several stages of fabrication including the deposition of certain semiconductor layers on the growth substrate up to the contact layer, according to the present disclosure.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale. A variety of different features of multijunction solar cells (as well as inverted metamorphic multijunction solar cells) are disclosed in the related applications noted above. Some, many or all of such features may be included in the structures associated with the lattice matched or "upright" solar cells of the present disclosure. More specifically, however, the present disclosure relates to four junction solar cells with direct band gaps in the range of 2.0 to 2.15 eV for the top subcell, and (i) 1.65 to 1.8 eV, and (ii) 1.41 eV for the middle subcells, and 0.67 eV indirect bandgaps, for the bottom subcell, respectively. Another way of characterizing the present disclosure is that of a four junction solar cell, the average band gap of all four subcells, namely the sum of the four band gaps of each subcell divided by four is greater than 1.44 eV. A relatively simple and reproducible technique is described that is not covered by the appended claims but is considered useful for understanding the invention, the technique not employing inverted processing associated with inverted metamorphic multijunction solar cells, and being suitable for use in a high volume production environment in which various semiconductor layers are grown on a growth substrate in an MOCVD reactor, and subsequent processing steps are defined and selected to minimize any physical damage to the quality of the deposited layers, thereby ensuring a relatively high yield of operable solar cells meeting specifications at the conclusion of the fabrication processes. One aspect of the present disclosure relates to the use of aluminum in the active layers of the upper subcells in a multijunction solar cell. The effects of increasing amounts of aluminum as a constituent element in an active layer of a subcell affects the photovoltaic device performance. One measure of the "quality" or "goodness" of a solar cell junction is the difference between the band gap of the semiconductor material in that subcell or junction and the V_{oc}, or open circuit voltage, of that same junction. The smaller the difference, the higher the V_{oc} of the solar cell junction relative to the band gap, and the better the performance of the device. V_{oc} is very sensitive to semiconductor material quality, so the smaller the E_{g} - V_{oc} of a device, the higher the quality of the material in that device. There is a theoretical limit to this difference, known as the Shockley-Queisser limit. That is the best that a solar cell junction can be under a given concentration of light at a given temperature. The experimental data obtained for single junction (Al)GaInP solar cells indicates that increasing the Al content of the junction leads to a larger V_{oc} - E_{g} difference, indicating that the material quality of the junction decreases with increasing Al content. Figure 1 shows this effect. The three compositions cited in the Figure are all lattice matched to GaAs, but have differing Al composition. Adding Al increases the band gap of the junction, but in so doing also increases V_{oc} - E_{g}. Hence, we draw the conclusion that adding Al to a semiconductor material degrades that material such that a solar cell device made out of that material does not perform relatively as well as a junction with less AL FIG. 2 illustrates a particular example of a multijunction solar cell device 303 as known in the prior art. In the Figure, each dashed line indicates the active region junction between a base layer and emitter layer of a subcell. As shown in the illustrated example of FIG. 2, the bottom subcell 205 includes a substrate 212 formed of p-type germanium ("Ge") which also serves as a base layer. A contact pad 213 formed on the bottom of base layer 212 provides electrical contact to the multijunction solar cell 203. The bottom subcell 205 further includes, for example, a highly doped n-type Ge emitter layer 214, and an n-type indium gallium arsenide ("InGaAs") nucleation layer 216. The nucleation layer is deposited over the base layer 212, and the emitter layer is formed in the substrate by diffusion of deposits into the Ge substrate, thereby forming the n-type Ge layer 214. Heavily doped p-type aluminum gallium arsenide ("AlGaAs") and heavily doped n-type gallium arsenide ("GaAs") tunneling junction layers 218, 217 may be deposited over the nucleation layer 216 to provide a low resistance pathway between the bottom and middle subcells. In the illustrated example of FIG. 2, the middle subcell 207 includes a highly doped p-type aluminum gallium arsenide ("AlGaAs") back surface field ("BSF") layer 220, a p-type InGaAs base layer 222, a highly doped n-type indium gallium phosphide ("InGaP2") emitter layer 224 and a highly doped n-type indium aluminum phosphide ("AlInP2") window layer 226. The InGaAs base layer 222 of the middle subcell 207 can include, for example, approximately 1.5% In. Other compositions maybe used as well. The base layer 222 is formed over the BSF layer 220 after the BSF layer is deposited over the tunneling junction layers 218 of the bottom subcell 204. The BSF layer 220 is provided to reduce the recombination loss in the middle subcell 207. The BSF layer 220 drives minority carriers from a highly doped region near the back surface to minimize the effect of recombination loss. Thus, the BSF layer 220 reduces recombination loss at the backside of the solar cell and thereby reduces recombination at the base layer/BSF layer interface. The window layer 226 is deposited on the emitter layer 224 of the middle subcell B. The window layer 226 in the middle subcell B also helps reduce the recombination loss and improves passivation of the cell surface of the underlying junctions. Before depositing the layers of the top cell C, heavily doped n-type InGaP and p-type AlGaAs tunneling junction layers 227, 228 may be deposited over the middle subcell B. In the illustrated example, the top subcell 209 includes a highly doped p-type indium gallium aluminum phosphide ("InGaP") BSF layer 230, a p-type InGaP2 base layer 232, a highly doped n-type InGaP2 emitter layer 234 and a highly doped n-type InAlP2 window layer 236. The base layer 232 of the top subcell 209 is deposited over the BSF layer 230 after the BSF layer 230 is formed over the tunneling junction layers 228 of the middle subcell 207. The window layer 236 is deposited over the emitter layer 234 of the top subcell after the emitter layer 234 is formed over the base layer 232. A cap or contact layer 238 may be deposited and patterned into separate contact regions over the window layer 236 of the top subcell 208. The cap or contact layer 238 serves as an electrical contact from the top subcell 209 to metal grid layer 240. The doped cap or contact layer 238 can be a semiconductor layer such as, for example, a GaAs or InGaAs layer. After the cap or contact layer 238 is deposited, the grid lines 240 are formed. The grid lines 240 are deposited via evaporation and lithographically patterned and deposited over the cap or contact layer 238. The mask is subsequently lifted off to form the finished metal grid lines 240 as depicted in the Figure, and the portion of the cap layer that has not been metallized is removed, exposing the surface 242 of the window layer 236. In some embodiments, a trench or channel (not shown), or portion of the semiconductor structure, is also etched around each of the solar cells. These channels define a peripheral boundary between the solar cell (later to be scribed from the wafer) and the rest of the wafer, and leaves a mesa structure (or a plurality of mesas, in the case of more than one solar cell per wafer) which define and constitute the solar cells later to be scribed and diced from the wafer. As more fully described in U.S. Patent Application Serial No. 12/218,582 filed July 18, 2008, the grid lines 240 are composed of Ti/Au/Ag/Au, although other suitable materials may be used as well. Turning to the multijunction solar cell device of the present disclosure, FIG. 3 is a cross-sectional view of an embodiment of a four junction solar cell 400 after several stages of fabrication including the growth of certain semiconductor layers on the growth substrate up to the contact layer 322, with various subcells being similar to the structure described and depicted in FIG. 2. As shown in the illustrated example of FIG. 3, the bottom subcell D includes a substrate 300 formed of p-type germanium ("Ge") which also serves as a base layer. A back metal contact pad 350 formed on the bottom of base layer 300 provides electrical contact to the multijunction solar cell 400. The bottom subcell D, further includes, for example, a highly doped n-type Ge emitter layer 301, and an n-type indium gallium arsenide ("InGaAs") nucleation layer 302. The nucleation layer is deposited over the base layer, and the emitter layer is formed in the substrate by diffusion of deposits into the Ge substrate, thereby forming the n-type Ge layer 301. Heavily doped p-type aluminum gallium arsenide ("AlGaAs") and heavily doped n-type gallium arsenide ("GaAs") tunneling junction layers 303, 304 may be deposited over the nucleation layer to provide a low resistance pathway between the bottom and middle subcells. Distributed Bragg reflector (DBR) layers 305 are then grown adjacent to and between the tunnel diode 303, 304 of the bottom subcell D and the third solar subcell C. The DBR layers 305 are arranged so that light can enter and pass through the third solar subcell C and at least a portion of which can be reflected back into the third solar subcell C by the DBR layers 305. In the embodiment depicted in FIG. 3, the distributed Bragg reflector (DBR) layers 305 are specifically located between the third solar subcell C and tunnel diode layers 304, 303; in other embodiments, the distributed Bragg reflector (DBR) layers may be located between tunnel diode layers 304/303 and buffer layer 302. For some embodiments, distributed Bragg reflector (DBR) layers 305 can be composed of a plurality of alternating layers 305a through 305z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength. For some embodiments, distributed Bragg reflector (DBR) layers 305a through 305z includes a first DBR layer composed of a plurality of p type AlₓGa₁₋ₓAs layers, and a second DBR layer disposed over the first DBR layer and composed of a plurality of p type Al_{y}Ga_{1-y}As layers, where y is greater than x. In the illustrated example of FIG. 3, the subcell C includes a highly doped p-type aluminum gallium arsenide ("AlGaAs") back surface field ("BSF") layer 306, a p-type InGaAs base layer 307, a highly doped n-type indium gallium arsenide ("InGaAs") emitter layer 308 and a highly doped n-type indium aluminum phosphide ("AlInP2") window layer 309. The InGaAs base layer 307 of the subcell C can include, for example, approximately 1.5% In. Other compositions may be used as well. The base layer 307 is formed over the BSF layer 306 after the BSF layer is deposited over the DBR layers 305. The window layer 309 is deposited on the emitter layer 308 of the subcell C. The window layer 309 in the subcell C also helps reduce the recombination loss and improves passivation of the cell surface of the underlying junctions. Before depositing the layers of the subcell B, heavily doped n-type InGaP and p-type AlGaAs (or other suitable compositions) tunneling junction layers 310, 311 may be deposited over the subcell C. The middle subcell B includes a highly doped p-type aluminum gallium arsenide ("AlGaAs") back surface field ("BSF") layer 312, a p-type AlGaAs base layer 313, a highly doped n-type indium gallium phosphide ("InGaP2") or AlGaAs layer 314 and a highly doped n-type indium gallium aluminum phosphide ("AlGaAlP") window layer 315. The InGaP emitter layer 314 of the subcell B can include, for example, approximately 50% In. Other compositions may be used as well. Before depositing the layers of the top cell A, heavily doped n-type InGaP and p-type AlGaAs tunneling junction layers 316, 317 may be deposited over the subcell B. In the illustrated example, the top subcell A includes a highly doped p-type indium aluminum phosphide ("InAlP2") BSF layer 318, a p-type InGaAlP base layer 319, a highly doped n-type InGaAlP emitter layer 320 and a highly doped n-type TnAlP2 window layer 321. The base layer 319 of the top subcell A is deposited over the BSF layer 318 after the BSF layer 318 is formed. After the cap or contact layer 322 is deposited, the grid lines are formed via evaporation and lithographically patterned and deposited over the cap or contact layer 322. The present disclosure provides a multijunction solar cell that follows a design rule that one should incorporate as many high band gap subcells as possible to achieve the goal to increase the efficiency at high temperature EOL. For example, high band gap subcells may retain a greater percentage of cell voltage as temperature increases, thereby offering lower power loss as temperature increases. As a result, both HT-BOL and HT-EOL performance of the exemplary multijunction solar cell, according to the present disclosure, may be expected to be greater than traditional cells. For example, the cell efficiency (%) measured at room temperature (RT) 28° C and high temperature (HT) 70° C, at beginning of life (BOL) and end of life (EOL), for a standard three junction commercial solar cell (ZTJ), such as depicted in FIG. 2, is as follows:

| Condition | Efficiency |
|---|---|
| BOL 28° C | 29.1% |
| BOL 70° C | 26.4% |
| | |
| EOL 70° C | 23.4% After 5E14 e/cm² radiation |
| EOL 70°C | 22.0% After 1E15 e/cm² radiation |

For the solar cell described in the present disclosure, the corresponding data is as follows:

| Condition | Efficiency |
|---|---|
| BOL 28° C | 29.1% |
| BOL 70° C | 26.5% |
| | |
| EOL 70° C | 24.9% After 5E14 e/cm² radiation |
| EOL 70° C | 24.4% After 1E15 e/cm² radiation |

The new solar cell has a slightly higher cell efficiency than the standard commercial solar cell (ZTJ) at BOL at 70° C. However, the solar cell described in the present disclosure exhibits substantially improved cell efficiency (%) over the standard commercial solar cell (ZTJ) at 1 MeV electron equivalent fluence of 5 x 10¹⁴ e/cm², and dramatically improved cell efficiency (%) over the standard commercial solar cell (ZTJ) at 1 MeV electron equivalent fluence of 1 x 10¹⁵ e/cm².

A low earth orbit (LEO) satellite will typically experience radiation equivalent to 5 x 10¹⁴ e/cm² over a five year lifetime. A geosynchronous earth orbit (GEO) satellite will typically experience radiation in the range of 5 x 10¹⁴ e/cm² to 1 x 10¹⁵ c/cm² over a fifteen year lifetime.

The wide range of electron and proton energies present in the space environment necessitates a method of describing the effects of various types of radiation in terms of a radiation environment which can be produced under laboratory conditions. The methods for estimating solar cell degradation in space are based on the techniques described by Brown et al [Brown, W. L., J. D. Gabbe, and W. Rosenzweig, Results of the Telstar Radiation Experiments, Bell System Technical J., 42, 1505, 1963] and Tada [Tada, H. Y., J.R. Carter, Jr., B.E. Anspaugh, and R. G. Downing, Solar Cell Radiation Handbook, Third Edition, JPL Publication 82-69, 1982]. In summary, the omnidirectional space radiation is converted to a damage equivalent unidirectional fluence at a normalised energy and in terms of a specific radiation particle. This equivalent fluence will produce the same damage as that produced by omnidirectional space radiation considered when the relative damage coefficient (RDC) is properly defined to allow the conversion. The relative damage coefficients (RDCs) of a particular solar cell structure are measured a priori under many energy and fluence levels in addition to different coverglass thickness values. When the equivalent fluence is determined for a given space environment, the parameter degradation can be evaluated in the laboratory by irradiating the solar cell with the calculated fluence level of unidirectional normally incident flux. The equivalent fluence is normally expressed in terms of 1 MeV electrons or 10 MeV protons.

The software package Spenvis (www.spenvis.oma.be) is used to calculate the specific electron and proton fluence that a solar cell is exposed to during a specific satellite mission as defined by the duration, altitude, azimuth, etc. Spenvis employs the EQFLUX program, developed by the Jet Propulsion Laboratory (JPL) to calculate 1 MeV and 10 MeV damage equivalent electron and proton fluences, respectively, for exposure to the fluences predicted by the trapped radiation and solar proton models for a specified mission environment duration. The conversion to damage equivalent fluences is based on the relative damage coefficients determined for multijunction cells [Marvin, D.C., Assessment of Multijunction Solar Cell Performance in Radiation Environments, Aerospace Report No. TOR-2000 (1210)-1, 2000], A widely accepted total mission equivalent fluence for a geosynchronous satellite mission of 15 year duration is 1MeV 1x10¹⁵ electrons/cm².

The exemplary solar cell described herein requires the use of aluminum in the semiconductor composition of each of the top two subcells. Aluminum incorporation is widely known in the III-V compound semiconductor industry to degrade BOL subcell performance due to deep level donor defects, higher doping compensation, shorter minority carrier lifetimes, and lower cell voltage and an increased BOL E_{g} - V_{oc} metric. In short, increased BOL E_{g} - V_{oc} may be the most problematic shortcoming of aluminum containing subcells; the other limitations can be mitigated by modifying the doping schedule or thinning base thicknesses.

It will be understood that each of the elements described above, or two or more together, also may find a useful application in other types of structures or constructions differing from the types of structures or constructions described above.

Without further analysis, from the foregoing others can, by applying current knowledge, readily adapt the present invention for various applications.

## Claims

1. A four junction solar cell comprising:
an upper first solar subcell composed of indium gallium aluminum phosphide and having a first band gap;
a second subcell adjacent to said first solar subcell including an emitter layer composed of indium gallium phosphide or aluminum gallium arsenide, and a base layer composed of aluminum gallium arsenide and having a second band gap smaller than the first band gap and being lattice matched with the upper first solar subcell;
a third solar subcell adjacent to said second solar subcell and composed of indium gallium arsenide and having a third band gap smaller than the second band gap and being lattice matched with the second solar subcell; and
a fourth solar subcell adjacent to said third solar subcell and composed of germanium and having a fourth band gap smaller than the third band gap, wherein the fourth subcell has a band gap of approximately 0.67 eV, and the second subcell has a band gap in the range of 1.65 to 1.8 eV, **characterized in that** the upper first subcell has a band gap in the range of 2.0 to 2.15 eV and the third subcell has a band gap of approximately 1.41 eV, wherein the average band gap of all four subcells, namely the sum of the four band gaps of each subcell divided by four is greater than 1.44 eV.

2. The four junction solar cell as defined in claim 1, the second subcell has a band gap of approximately 1.73 eV and the upper first subcell has a band gap of approximately 2.10 eV.

3. The four junction solar cell as defined in claim 1, further comprising:a distributed Bragg reflector (DBR) layer adjacent to and between the third and the fourth solar subcells and arranged so that light can enter and pass through the third solar subcell and at least a portion of which can be reflected back into the third solar subcell by the DBR layer.

4. The four junction solar cell as defined in claim 3, wherein the distributed Bragg reflector layer is composed of a plurality of alternating layers of lattice matched materials with discontinuities in their respective indices of refraction.

5. The four junction solar cell as defined in claim 4, wherein the difference in refractive indices between alternating layers is maximized in order to minimize the number of periods required to achieve a given reflectivity, and the thickness and refractive index of each period determines the stop band and its limiting wavelength.

6. The four junction solar cell as defined in claim 5, wherein the DBR layer includes a first DBR layer composed of a plurality of p type Alₓ Ga₁₋ₓAs layers, and a second DBR layer disposed over the first DBR layer and composed of a plurality of p type Al_{y} Ga_{1-y}As layers, where y is greater than x.

## Patentansprüche

1. Vierfachsolarzelle, die Folgendes umfasst:
eine obere erste Solarteilzelle, die aus Indium-Gallium-Aluminium-Phosphid besteht und eine erste Bandlücke aufweist;
eine der ersten Solarteilzelle benachbarte zweite Teilzelle, umfassend eine aus Indium-Gallium-Phosphid oder Aluminium-Gallium-Arsenid bestehende Emitterschicht und eine aus Aluminium-Gallium-Arsenid bestehende Basisschicht, die zweite Bandlücke aufweist, die kleiner ist als die erste Bandlücke, und die an die obere erste Solarteilzelle gitterangepasst ist;
eine der zweiten Solarteilzelle benachbarte dritte Solarteilzelle, die aus Indium-Gallium-Arsenid besteht und eine dritte Bandlücke aufweist, die kleiner ist als die zweite Bandlücke, und die an die zweite Solarteilzelle gitterangepasst ist; und
eine der dritten Solarteilzelle benachbarte vierte Solarteilzelle, die aus Germanium besteht und eine vierte Bandlücke aufweist, die kleiner ist als die dritte Bandlücke, wobei die vierte Teilzelle eine Bandlücke von ungefähr 0,67 eV aufweist und die zweite Teilzelle eine Bandlücke im Bereich von 1,65 bis 1,8 eV aufweist, **dadurch gekennzeichnet, dass** die obere erste Teilzelle eine Bandlücke im Bereich von 2,0 bis 2,15 eV aufweist und die dritte Teilzelle eine Bandlücke von ungefähr 1,41 eV aufweist, wobei die durchschnittliche Bandlücke aller vier Teilzellen, das heißt die Summe der vier Bandlücken jeder Teilzelle geteilt durch vier, größer ist als 1.44 eV.

2. Vierfachsolarzelle nach Anspruch 1, wobei die zweite Teilzelle eine Bandlücke von ungefähr 1,73 eV aufweist und die obere erste Teilzelle eine Bandlücke von ungefähr 2,10 eV aufweist.

3. Vierfachsolarzelle nach Anspruch 1, die ferner Folgendes umfasst:
eine Bragg-Spiegelschicht (Distributed Bragg Reflector, DBR) zwischen der dritten und der vierten Solarteilzelle und diesen benachbart, die derart angeordnet ist, dass Licht in die dritte Solarteilzelle eintreten und dadurch hindurch gelangen kann und mindestens ein Anteil davon von der DBR-Schicht in die dritte Solarteilzelle zurückreflektiert werden kann.

4. Vierfachsolarzelle nach Anspruch 3, wobei die Bragg-Spiegelschicht aus einer Vielzahl von abwechselnden Schichten gitterangepasster Materialien mit Diskontinuitäten in ihren entsprechenden Brechungsindizes besteht.

5. Vierfachsolarzelle nach Anspruch 4, wobei die Differenz zwischen den Brechungsindizes abwechselnder Schichten maximiert ist, um die Zahl der Perioden zu minimieren, die benötigt wird, um einen gegebenen Reflexionsgrad zu erreichen, und wobei die Dicke und der Brechungsindex jeder Periode das Sperrband und dessen Grenzwellenlänge bestimmen.

6. Vierfachsolarzelle nach Anspruch 5, wobei die DBR-Schicht eine aus einer Vielzahl von p-leitenden AlₓGa₁₋ₓAs-Schichten bestehende erste DBR-Schicht und eine zweite DBR-Schicht, die über der ersten DBR-Schicht angeordnet ist und aus einer Vielzahl von p-leitenden Al_{y}Ga_{1-y}As-Schichten besteht, umfasst, wobei y größer ist als x.

## Revendications

1. Cellule solaire à quatre jonctions comprenant :
une première sous-cellule solaire supérieure composée de phosphure d'indium, de gallium et d'aluminium et ayant une première bande interdite ;
une deuxième sous-cellule adjacente à ladite première sous-cellule solaire incluant une couche émettrice composée de phosphure d'indium et de gallium ou d'arséniure d'aluminium et de gallium, et une couche de base composée d'arséniure d'aluminium et de gallium et ayant une deuxième bande interdite plus petite que la première bande interdite et dont le réseau correspond à la première sous-cellule solaire supérieure ;
une troisième sous-cellule solaire adjacente à ladite deuxième sous-cellule solaire et composée d'arséniure d'indium et de gallium et ayant une troisième bande interdite plus petite que la deuxième bande interdite et dont le réseau correspond à la deuxième sous-cellule solaire ; et
une quatrième sous-cellule solaire adjacente à ladite troisième sous-cellule solaire et composée de germanium et ayant une quatrième bande interdite plus petite que la troisième bande interdite, dans laquelle la quatrième sous-cellule a une bande interdite d'approximativement 0,67 eV, et la deuxième sous-cellule a une bande interdite comprise dans la plage de 1,65 à 1,8 eV, **caractérisée en ce que** la première sous-cellule supérieure a une bande interdite comprise dans la plage de 2,0 à 2,15 eV et la troisième sous-cellule a une bande interdite d'approximativement 1,41 eV, dans laquelle la bande interdite moyenne de l'ensemble des quatre sous-cellules, à savoir la somme des quatre bandes interdites de chaque sous-cellule divisée par quatre, est supérieure à 1,44 eV.

2. Cellule solaire à quatre jonctions selon la revendication 1, dans laquelle la deuxième sous-cellule a une bande interdite d'approximativement 1,73 eV et la première sous-cellule supérieure a une bande interdite d'approximativement 2,10 eV.

3. Cellule solaire à quatre jonctions selon la revendication 1, comprenant en outre :
une couche de réflecteur de Bragg distribué (DBR) adjacente à la troisième et à la quatrième sous-cellule solaire et entre la troisième et la quatrième sous-cellule solaire et disposée de sorte que de la lumière peut entrer et traverser la troisième sous-cellule solaire et dont au moins une partie peut être réfléchie en retour dans la troisième sous-cellule solaire par la couche DBR.

4. Cellule solaire à quatre jonctions selon la revendication 3, dans laquelle la couche de réflecteur de Bragg distribué est composée d'une pluralité de couches alternées de matériaux dont les réseaux correspondent avec des discontinuités dans leurs indices de réfraction respectifs.

5. Cellule solaire à quatre jonctions selon la revendication 4, dans laquelle la différence des indices de réfraction entre des couches alternées est rendue maximale afin de rendre minimal le nombre de périodes nécessaires pour atteindre une réflectivité donnée, et l'épaisseur et l'indice de réfraction de chaque période déterminent la bande d'arrêt et sa longueur d'onde limite.

6. Cellule solaire à quatre jonctions selon la revendication 5, dans laquelle la couche DBR inclut une première couche DBR composée d'une pluralité de couches AlₓGa₁₋ₓAs de type p, et une deuxième couche DBR disposée sur la première couche DBR et composée d'une pluralité de couches Al_{y}Ga_{1-y}As de type p, où y est supérieur à x.
